# FASCICULE DE BREVET EUROPEEN

(11) **EP 4 002 491 B1**
(45) Date de publication et mention de la délivrance du brevet: **19.07.2023**
(21) Numéro de dépôt: 21208798.5
(22) Date de dépôt: 17.11.2021
(51) Int. Cl.: H01L 31/048

(54) **MODULE PHOTOVOLTAÏQUE LÉGER ET FLEXIBLE AMELIORÉ**
VERBESSERTES LEICHTES UND FLEXIBLES FOTOVOLTAIKMODUL
IMPROVED LIGHT AND FLEXIBLE PHOTOVOLTAIC MODULE

(30) Priorité: 23.11.2020 FR 2012016
(43) Date de publication de la demande: 25.05.2022
(73) Titulaire: Commissariat à l'Energie Atomique et aux Energies Alternatives, 75015 Paris (FR); THALES, 92400 Courbevoie (FR); Concept Composites Auvergne- 2CA, 63220 Arlanc (FR)
(72) Inventeur: GAUME, Julien, 38054 GRENOBLE Cedex 09 (FR); CHAIX, Rodolphe, 06156 CANNES LA BOCCA Cedex (FR); BILLARD, Jean-Baptiste, 06156 CANNES LA BOCCA Cedex (FR); GUERIN, Thomas, 38054 GRENOBLE Cedex 09 (FR); RUOLS, Pierre, 73000 CHAMBERY (FR)
(74) Mandataire: Atout PI Laplace

(56) Documents cités:
- EP-A1- 2 450 967
- CN-U- 203 367 314
- JP-A- 2002 141 542
- RU-U1- 178 429
- US-B1- 9 004 410

## Description

### Domaine technique de l'invention

La présente invention se rapporte au domaine des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin.

Plus précisément, la présente invention se rapporte au domaine des modules photovoltaïques ultra-légers (poids surfacique inférieur à 1 kg/m² voire inférieur à 800 g/m², voire encore inférieur à 600 g/m²) et flexibles.

L'invention peut être mise en oeuvre pour de nombreuses applications, par exemple des applications autonomes et/ou embarquées, étant particulièrement concernée par les applications qui requièrent l'utilisation de modules photovoltaïques flexibles, sans verre et ultra-légers, en particulier d'un poids par unité de surface inférieur à 1 kg/m², et notamment inférieur à 800 g/m², voire encore inférieur à 600 g/m², et de faible épaisseur, notamment inférieure à 1 mm. Elle peut ainsi notamment être appliquée pour des bâtiments tels que des habitats ou locaux industriels (tertiaires, commerciaux,...), par exemple pour la réalisation de leurs toitures, pour la conception de mobilier urbain, par exemple pour de l'éclairage public, la signalisation routière ou encore la recharge de voitures électriques, voire également être utilisée pour des applications nomades, en particulier pour une intégration sur des objets volants, des voitures, bus ou bateaux, entre autres.

### Etat de la technique

Un module photovoltaïque est un assemblage de cellules photovoltaïques disposées côte à côte entre une première couche formant une face avant du module photovoltaïque et une seconde couche formant une face arrière du module photovoltaïque. La première couche formant la face avant du module photovoltaïque est transparente pour permettre aux cellules photovoltaïques de recevoir un flux lumineux.

Les cellules photovoltaïques peuvent être reliées électriquement entre elles par des éléments de contact électrique avant et arrière, appelés conducteurs de liaison, et formés par exemple par des bandes de cuivre étamé, respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques, ou bien encore uniquement en face arrière pour les cellules photovoltaïques de type IBC (pour « Interdigitated Back Contact » en anglais).

Par ailleurs, les cellules photovoltaïques, situées entre les première et deuxième couches formant respectivement les faces avant et arrière du module photovoltaïque, peuvent être encapsulées.

La demande de brevet WO2019224458A1 décrit un module photovoltaïque ultra-léger représenté en figure 1. Le module photovoltaïque **1** comprend :
- une première couche transparente **2,** formant la face avant du module photovoltaïque, et comportant au moins un matériau polymère et présente une épaisseur **e2** inférieure à 50 µm ;
- la deuxième couche **5,** pouvant former la face arrière du module photovoltaïque, comportant au moins un matériau composite de type préimprégné à base de résine polymère et de fibres, et présentant un poids surfacique inférieur à 150 g/m² ;
- une pluralité de cellules photovoltaïques **4** disposées côte à côte et reliées électriquement entre elles par des éléments de contact électrique sous forme de rubans d'interconnexion,
- un ensemble **3** (formé par deux couches **3a** et **3b)** encapsulant la pluralité de cellules photovoltaïques et présentant une épaisseur maximale **e3** inférieure à 150 µm ; l'ensemble encapsulant et la pluralité de cellules photovoltaïques étant situés entre les première et deuxième couches.

La flèche correspond au rayonnement lumineux qui arrive sur la première couche transparente **2,** formant la face avant du module photovoltaïque.

La réalisation du module photovoltaïque **1** est effectuée en une seule étape de lamination à chaud, à une température comprise entre 130°C et 170°C et pendant une durée du cycle de lamination d'au moins 10 minutes des couches constitutives **2, 3, 4, 5** formant le module photovoltaïque **1.**

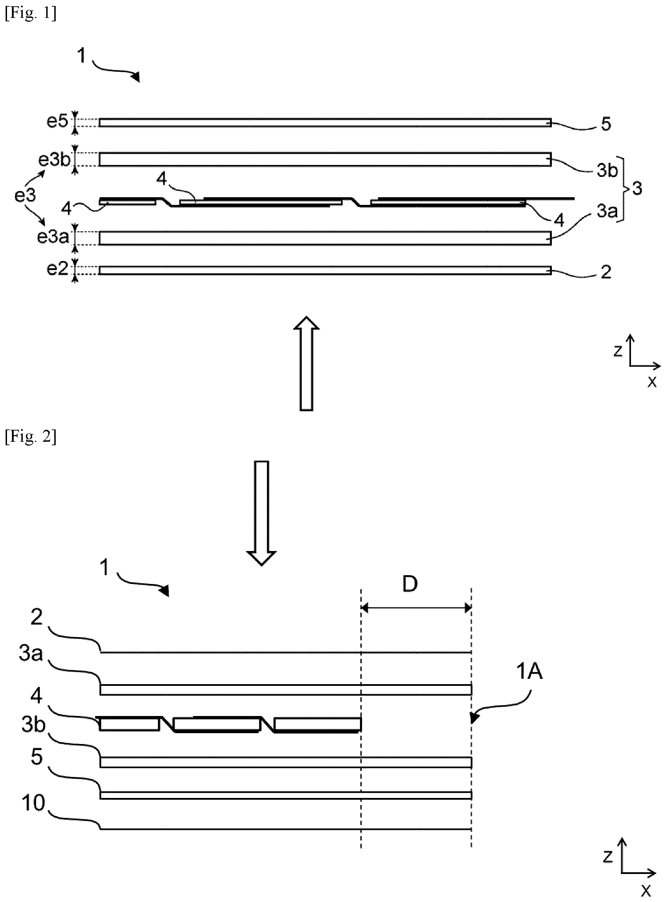

Comme illustré en figure 2, en pratique, les première et deuxième couches ainsi que l'ensemble encapsulant les cellules photovoltaïques présentent un débord **D** par rapport aux cellules photovoltaïques sur au moins un bord **1A** d'un tel module photovoltaïque **1.**

En d'autres termes, les cellules photovoltaïques sont distantes des bords du module formés par les première et deuxième couches ainsi que par l'ensemble encapsulant les cellules photovoltaïques (distance égale à la valeur du débord **D**). Ceci permet de protéger au mieux lesdites cellules, sur laquelle le module photovoltaïque comprend en outre en face arrière une couche additionnelle **10** constituée par le même matériau que celui constituant la première couche **2** formant la face avant du module photovoltaïque 1.

La figure 2 représente un seul bord, mais un débord existe généralement sur tous les bords du module et il est généralement de même largeur sur tous les bords.

L'ensemble encapsulant doit généralement présenter un débord d'au moins 16 mm (depuis le bord du dernier conducteur électrique, cellule ou ruban d'interconnexion) voire davantage, pour assurer l'isolation électrique lorsque l'opération de lamination est réalisée, si le module est soumis à une tension de fonctionnement de 1000 V. Ce débord permet aussi d'assurer l'étanchéité hydrique et chimique du module. Les première et deuxième couches suivent les dimensions de l'ensemble encapsulant. Ce débord peut être plus faible si les matériaux utilisés ont des rigidités électriques très élevées, si la tension de fonctionnement du module est plus faible ou bien si les conditions environnementales d'utilisation du module ne nécessitent pas une étanchéité hydrique ou chimique élevée. Dans tous les cas, pour des raisons de facilité de procédé, le débord est très souvent d'au moins 5 mm.

En outre, certaines applications de ces modules photovoltaïques ultra-légers (par exemple pour une intégration sur un objet volant) supposent souvent de les fixer à un objet par l'intermédiaire de moyens de fixation disposés au niveau des bords du module, et non par l'intermédiaire de la face arrière comme cela peut être le cas pour d'autres modules photovoltaïques et/ou d'autres applications.

Or les inventeurs ont constaté que pour un module photovoltaïque ultra-léger tel que précédemment décrit, les contraintes internes après lamination, liées à la dissymétrie de la structure obtenue, conduisent à une courbure sur les bords du module. Les courbures peuvent alors compliquer, gêner voire empêcher l'utilisation des moyens de fixation susmentionnés. Les courbures peuvent en outre présenter des risques d'accrochages ou des problèmes de prise au vent, voire des défauts esthétiques qui ne sont pas compatibles avec certaines applications.

L'invention vise à surmonter les inconvénients précités de l'art antérieur.

Plus particulièrement, l'invention vise à disposer d'un module photovoltaïque ultra-léger et flexible dont les bords ne présentent pas ou peu de courbure, tout en présentant des propriétés mécaniques et des performances électriques au moins équivalentes à celles des modules photovoltaïques ultra-légers et flexibles de l'art antérieur. En d'autres termes, l'invention vise à obtenir des modules photovoltaïques ultra-légers et flexibles les plus plats possibles.

Le document RU178429U1 donne un exemple connu de bandes de renforcement disposées en périphérie du module photovoltaïque (référence 8 sur 1a figure 1 de ce document).

### Exposé de l'invention

Un premier objet de l'invention permettant de remédier à ces inconvénients est un module photovoltaïque comportant :
- une première couche transparente formant la face avant du module photovoltaïque destinée à recevoir un flux lumineux,
- une pluralité de cellules photovoltaïques disposées côte à côte et reliées électriquement entre elles,
- un ensemble encapsulant apte à encapsuler la pluralité de cellules photovoltaïques, présentant une partie inférieure et une partie supérieure, l'ensemble encapsulant étant de préférence en polymère,
- une deuxième couche comportant au moins un matériau composite à base de résine polymère et de fibres, l'ensemble encapsulant et la pluralité de cellules photovoltaïques étant situés entre les première et deuxième couches,
au moins la première couche et la deuxième couche définissant les bords du module photovoltaïque; caractérisé en ce que la pluralité de cellules photovoltaïques est espacée d'une distance D_{A} non nulle d'au moins un bord du module photovoltaïque, et en ce que le module photovoltaïque comprend en outre une troisième couche, ou couche de renforcement, située en dessous de la pluralité de cellules photovoltaïques et au-dessus de la partie inférieure de l'ensemble encapsulant, ladite troisième couche formant au moins une bande périphérique s'étendant depuis le au moins un bord vers le centre dudit module et dont la largeur est supérieure ou égale à la distance D_{A} ; ladite troisième couche comportant au moins un matériau composite à base de résine polymère et de fibres.

De préférence, l'écart entre la largeur de la au moins une bande périphérique et la distance D_{A} entre la pluralité de cellules photovoltaïques et le au moins un bord est inférieur ou égale à 30 mm, encore plus préférentiellement inférieur ou égale à 20 mm.

De préférence, la largeur de la au moins une bande périphérique de la troisième couche est strictement supérieure à la au moins une distance entre les cellules photovoltaïques et le au moins un bord

De préférence, la deuxième couche est en un matériau préimprégné à base de résine polymère et de fibres.

De préférence, la troisième couche est en un matériau préimprégné à base de résine polymère et de fibres.

Par « bande », il faut comprendre un élément s'étendant longitudinalement selon la direction du bord et dont la largeur est définie perpendiculairement à la direction du bord dans le plan du module photovoltaïque.

Une bande est dite « périphérique » en ce qu'elle est disposée au niveau d'un bord du module photovoltaïque. Ainsi, une bande périphérique est disposée depuis un bord de la cellule photovoltaïque et atteint, voire déborde sous, la (ou les) cellule(s) photovoltaïque(s) le(s) plus proche(s) du bord.

La « distance » entre un bord et la pluralité de cellules photovoltaïques sous-entend la distance la plus courte entre ledit bord et la (ou les) cellule(s) photovoltaïque(s) le(s) plus proche(s) du bord.

Les distances entre tous les bords du module photovoltaïque et la pluralité de cellules photovoltaïques peuvent être toutes identiques. Dans ce cas, les largeurs de bandes périphériques peuvent être toutes identiques également.

Les épaisseurs des cellules et des différentes couches, et notamment des bandes périphériques, sont définies selon la direction perpendiculaire au plan du module photovoltaïque.

Le terme « transparent » signifie que le matériau de la première couche formant la face avant du module photovoltaïque est au moins partiellement transparent à la lumière visible, laissant passer au moins environ 80 % de cette lumière.

La « face avant » du module photovoltaïque correspond à la face destinée à recevoir un flux lumineux. Elle peut être désignée par « face supérieure ». La « face arrière » correspond à la face opposée dudit module. Elle peut être désignée par « face inférieure ». Les termes « en dessous » et « inférieur » sont à comprendre par référence à la face arrière du module photovoltaïque. A l'inverse, le terme « au-dessus » et « supérieur » sont à comprendre par référence à la face avant du module photovoltaïque.

En outre, par le terme «encapsulant » ou « encapsulé », il faut comprendre que la pluralité de cellules photovoltaïques est disposée dans un volume, par exemple hermétiquement étanche vis-à-vis des liquides, au moins en partie formé par au moins deux couches de matériau(x) d'encapsulation, réunies entre elles après lamination pour former l'ensemble encapsulant.

En effet, initialement, c'est-à-dire avant toute opération de lamination, l'ensemble encapsulant est constitué par au moins deux couches de matériau(x) d'encapsulation, dites couches de coeur, entre lesquelles la pluralité de cellules photovoltaïques est encapsulée. Toutefois, pendant l'opération de lamination des couches, les couches de matériau d'encapsulation fondent pour ne former, après l'opération de lamination, qu'une seule couche (ou ensemble) solidifiée dans laquelle sont noyées les cellules photovoltaïques.

Ainsi l'invention vise à améliorer la symétrie des matériaux dans les zones sans cellules photovoltaïques et éventuellement sans rubans inter-connecteurs, en ajoutant une ou plusieurs bandes périphériques (couche de renforcement) uniquement dans ces zones et/ou en modifiant d'autres couches constitutives du module. Cela permet d'éviter la création de courbures sur les bords du module photovoltaïque.

Ces bandes périphériques peuvent être dans des matériaux constitutifs des couches déjà présentes dans le module photovoltaïque, comme le matériau composite à base de résine polymère et de fibres de la deuxième couche. Ces bandes périphériques localisées sur les bords ont pour but de symétriser la structure du module photovoltaïque au niveau des bords, et au mieux d'en améliorer la symétrie, tout en respectant les autres contraintes en fonction de l'application visée du module photovoltaïque.

Une solution évidente aurait été, partant du module photovoltaïque de la figure 2, de positionner une autre couche en le matériau composite de type préimprégné à base de résine polymère et de fibres (comme 1a deuxième couche) entre la première couche transparente et la couche d'encapsulant supérieure, et ce, afin de rétablir une symétrie entre les différentes couches. L'invention se distingue d'une telle solution en positionnant une troisième couche ou couche de renforcement entre la pluralité de cellules photovoltaïques et la partie inférieure de l'ensemble encapsulant et en conférant à ladite troisième couche une forme de bande périphérique (ou de cadre périphérique si tous les bords sont pourvus d'une bande de la troisième couche). D'une part, cela permet de protéger la troisième couche des rayons lumineux (elle reste en dessous des cellules), et d'éviter une perte de performance (avant d'atteindre les cellules, les rayons n'ont pas à traverser une couche supplémentaire). Le procédé de fabrication du module selon l'invention est aussi simple que celui du module photovoltaïque ultra-léger de l'art antérieur. En outre, le fait de positionner une bande uniquement au niveau des bords et non une couche entière permet une économie de matériau, qui peut être très avantageuse pour des modules photovoltaïques de grande taille. Enfin, cela évite de rajouter un poids trop important au module photovoltaïque.

Ces bandes périphériques permettent ainsi de former un module photovoltaïque ultra-léger et plat, sans courbure, facilitant l'utilisation d'un système de fixation du module photovoltaïque, et ce, sans augmenter considérablement le poids par unité de surface et le prix de revient d'un tel module.

Le module photovoltaïque selon l'invention peut en outre comporter l'une ou plusieurs des caractéristiques suivantes prises isolément ou suivant toutes combinaisons techniques possibles. En d'autres termes, les modes de réalisation indiqués dans ce qui suit peuvent être combinés entre eux, sauf lorsqu'il s'agit explicitement d'un mode alternatif à un autre.

Selon un mode de réalisation, la troisième couche et/ou la deuxième couche est en matériau composite à base de polymère et de fibres, le polymère étant choisi de préférence parmi le polyester, l'époxy et/ou l'acrylique ; et/ou les fibres étant choisies de préférence parmi les fibres de verre, de carbone et/ou d'aramide.

Selon un mode de réalisation préféré, la troisième couche est en le même matériau composite que la deuxième couche.

Selon un mode de réalisation particulier, la troisième couche forme plusieurs bandes périphériques, de préférence au moins deux bandes opposées, et encore plus préférentiellement quatre bandes, chaque bande périphérique s'étendant depuis un bord du module photovoltaïque vers le centre dudit module, la largeur de chaque bande périphérique étant supérieure ou égale à la distance D_{A}, D_{B},

D_{C}, D_{D} entre ledit bord et la pluralité de cellules photovoltaïques. De préférence, l'écart entre la largeur de chaque bande périphérique et la distance D_{A}, D_{B}, D_{C}, D_{D} est inférieur ou égal à 30 mm, et encore plus préférentiellement inférieur ou égal à 20 mm.

De préférence, la largeur de chaque bande périphérique de la troisième couche est strictement supérieure à la distance D_{A}, D_{B}, D_{C}, D_{D}.

Selon un mode de réalisation, l'ensemble encapsulant s'étend jusqu'aux bords du module photovoltaïque.

Selon un mode de réalisation alternatif au mode précédent, la partie supérieure de l'ensemble encapsulant est espacée d'une distance D_{3A} du au moins un bord du module photovoltaïque, la distance D_{3A} étant non nulle et inférieure à la distance D_{A} entre ledit au moins un bord et la pluralité de cellules photovoltaïques, l'écart entre lesdites distances D_{A} et D_{3A} étant de préférence inférieur ou égal à 10 mm. En particulier, la partie supérieure de l'ensemble encapsulant peut-être espacée d'une distance D_{3A}, D_{3B}, D_{3C}, D_{3D} non nulle de chaque bord du module photovoltaïque, l'écart entre la distance D_{3A}, D_{3B}, D_{3C}, D_{3D} et la distance D_{A}, D_{B}, D_{C}, D_{D} entre ledit bord et la pluralité de cellules photovoltaïques étant de préférence inférieur ou égal à 10 mm.

Selon un mode de réalisation, le module photovoltaïque comprend en outre une cinquième couche, de préférence en polymère, située en dessous de la deuxième couche, ladite cinquième couche formant au moins une bande périphérique s'étendant depuis le au moins un bord vers le centre dudit module et dont la largeur est supérieure ou égale à la distance D_{A} entre ledit au moins un bord et la pluralité de cellules photovoltaïques. De préférence, l'écart entre ladite largeur et ladite distance est inférieur ou égal à 30 mm, et encore plus préférentiellement inférieur ou égal à 20 mm.

Selon un mode de réalisation particulier, la cinquième couche forme plusieurs bandes périphériques, de préférence au moins deux bandes opposées, et encore plus préférentiellement quatre bandes, chaque bande périphérique s'étendant depuis un bord du module photovoltaïque vers le centre dudit module et la largeur de chaque bande périphérique étant supérieure ou égale à la distance D_{A}, D_{B}, D_{C}, D_{D} entre ledit bord et la pluralité de cellules photovoltaïques. De préférence, l'écart entre la largeur de chaque bande périphérique et la distance D_{A}, D_{B}, D_{C}, D_{D} est inférieur ou égal à 30 mm, et encore plus préférentiellement inférieur ou égal à 20 mm.

De préférence, la largeur de chaque bande périphérique de la cinquième couche est strictement supérieure à la distance D_{A}, D_{B}, D_{C}, D_{D}.

Ladite cinquième couche est de préférence en le même polymère que le matériau de l'ensemble encapsulant, ou au moins un polymère ayant les mêmes propriétés thermomécaniques.

Selon un mode de réalisation particulier, les dimensions de la cinquième couche sont sensiblement égales aux dimensions de la troisième couche.

Selon un mode de réalisation, le module photovoltaïque comprend en outre :
- une quatrième couche formant la face arrière du module photovoltaïque, la deuxième couche étant située entre l'ensemble encapsulant et ladite quatrième couche, ladite quatrième couche étant constituée par le même matériau que celui constituant la première couche, et présentant une épaisseur inférieure ou égale à celle de la première couche.

Le module photovoltaïque peut en outre présenter les caractéristiques additionnelles suivantes prises isolément ou en combinaison les unes avec les autres, ainsi qu'avec une ou plusieurs des caractéristiques précédentes :
- la première couche est en un matériau polymère ;
- la première couche présente une épaisseur inférieure ou égale à 50 µm ;
- l'ensemble encapsulant présente une épaisseur maximale inférieure à 150 µm ;
- la deuxième couche présente un poids surfacique inférieur à 150 g/m² ;
- l'ensemble encapsulant comprend une couche supérieure d'encapsulant disposée entre la première couche et la pluralité de cellules photovoltaïques et une couche inférieure d'encapsulant disposée entre la pluralité de cellules photovoltaïques et la deuxième couche.

Un deuxième objet de l'invention est un procédé de réalisation d'un tel module photovoltaïque comportant au moins une étape de lamination à chaud, à une température comprise entre 130°C et 170°C, notamment de l'ordre de 150°C, et pendant une durée du cycle de lamination d'au moins 10 minutes, notamment comprise entre 10 et 20 minutes, des couches constitutives du module photovoltaïque.

Le module photovoltaïque et le procédé de réalisation selon l'invention peuvent comporter l'une quelconque des caractéristiques précédemment énoncées, prises isolément ou selon toutes combinaisons techniquement possibles avec d'autres caractéristiques.

### Brève description des figures

D'autres caractéristiques et avantages de l'invention apparaîtront à l'aide de la description qui suit, donnée à titre illustratif et non limitatif, faite en regard des figures annexées parmi lesquelles
[Fig.1] représente un module photovoltaïque de l'art antérieur.
[Fig.2] représente un module photovoltaïque particulier de l'art antérieur.
[Fig.3] illustre, en coupe et en vue éclatée, un premier mode de réalisation d'un module photovoltaïque conforme à l'invention.
[Fig.4] illustre, en vue de dessus, un exemple de réalisation particulier du premier mode de réalisation d'un module photovoltaïque conforme à l'invention.
[Fig.5] illustre, en coupe et en vue éclatée, une variante du premier mode de réalisation d'un module photovoltaïque conforme à l'invention.
[Fig.6] illustre, en coupe et en vue éclatée, un deuxième mode de réalisation d'un module photovoltaïque conforme à l'invention.
[Fig.7] illustre, en coupe et en vue éclatée, un troisième mode de réalisation d'un module photovoltaïque conforme à l'invention.
[Fig.8] illustre, en vue de dessous, un exemple de réalisation particulier du troisième mode de réalisation d'un module photovoltaïque conforme à l'invention.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### Description détaillée de l'invention

Les figures 1 et 2 ont déjà été décrites dans la partie relative à l'état de la technique.

Dans l'ensemble des figures en coupe, la flèche correspond au rayonnement lumineux.

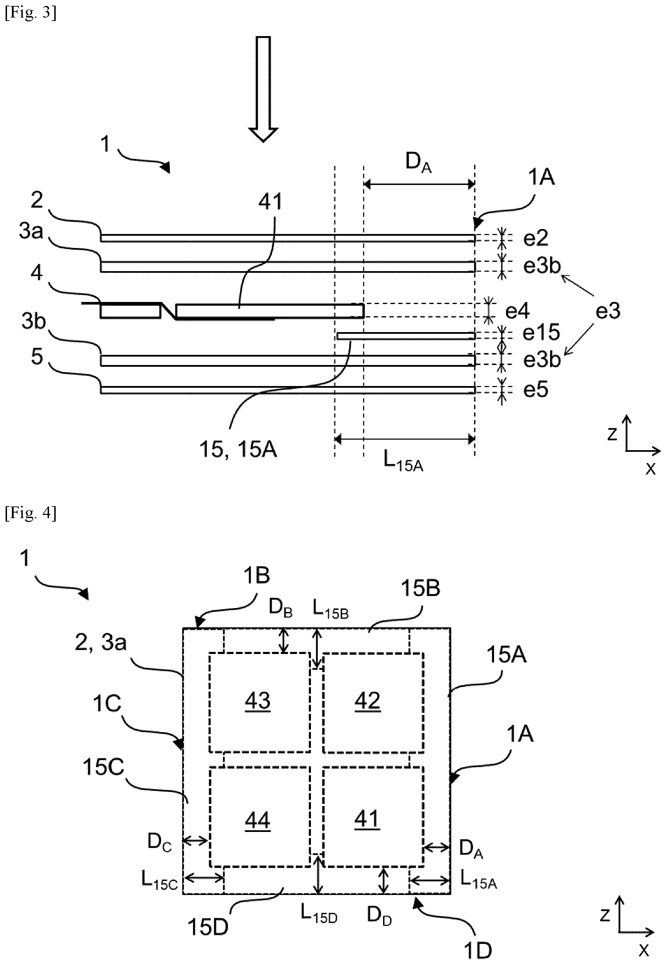

Il est à noter que les figures 3, 5, 6 et 7 correspondent à des coupes XZ en vues éclatées de trois modes et une variante de réalisation de module photovoltaïque avant l'étape de lamination du procédé de fabrication selon l'invention. Une fois l'étape de lamination réalisée, assurant un pressage à chaud et sous vide, les différentes couches sont en réalité superposées les unes aux autres selon un plan principal XY.

La figure 4 correspond à une vue de dessus XY d'un exemple de réalisation particulier du premier mode de réalisation.

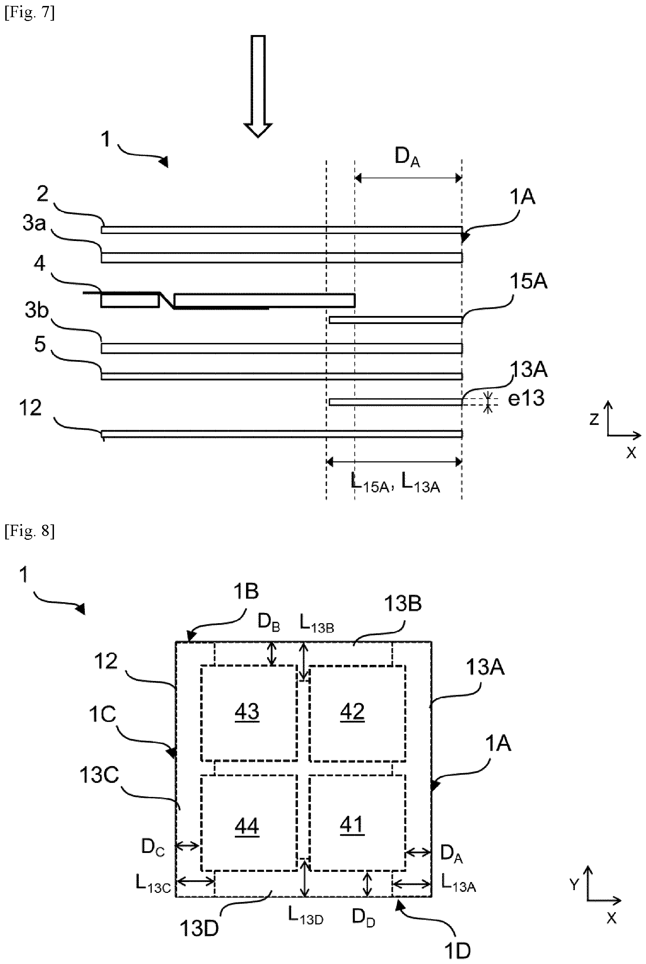

La figure 8 correspond à une vue de dessus XY d'un exemple de réalisation particulier du troisième mode de réalisation.

Dans l'ensemble des figures 3 à 8, et de manière plus générale dans le cadre de l'invention, le module photovoltaïque peut comprendre l'une ou plusieurs parmi les caractéristiques suivantes.

De préférence, la première couche 2, et la quatrième couche 12 le cas échéant, comporte au moins un matériau polymère.

Le matériau polymère de la première couche 2 (et de la quatrième couche 12 le cas échéant) peut être choisi parmi : le polycarbonate (PC), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le Polychlorotrifluoroéthylène (PCTFE) et/ou l'éthylène propylène fluoré (FEP).

La première couche 2 (et la quatrième couche 12 le cas échéant) présente une épaisseur inférieure à 50 µm, et avantageusement comprise entre 5µm et 25 µm.

L'ensemble encapsulant 3 (et la cinquième couche 13 le cas échéant) peut être réalisé à partir d'au moins un matériau polymère choisi parmi : les copolymères d'acides, les ionomères, le poly(éthylène-acétate de vinyle) (EVA), les acétals de vinyle, tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'a-oléfines et des α-, β- esters d'acide carboxylique à éthylénique, tels que les copolymères éthylène-acrylate de méthyle et les copolymères éthylène-acrylate de butyle, les élastomères de silicone et/ou les résines époxy.

L'ensemble encapsulant 3 présente une épaisseur totale e3 qui est inférieure ou égale à 150 µm, et préférentiellement comprise entre 20 et 100 µm, et encore préférentiellement comprise entre 50 µm et 75 µm.

L'ensemble encapsulant 3 peut notamment être réalisé à partir de deux couches en matériau polymère 3a (couche d'encapsulant supérieure) et 3b (couche d'encapsulant inférieure). Il peut s'agir de deux couches de poly(éthylène-acétate de vinyle) (EVA) ou deux couches de ionomère, entre lesquelles sont disposées les cellules photovoltaïques 4. Chaque couche 3a, 3b peut présenter une épaisseur e3a, e3b inférieure ou égale à 75 µm, et de préférence inférieure ou égale à 50 µm. Ces couches 3a et 3b, bien que préférentiellement de nature identique, peuvent avoir des propriétés optiques différentes.

Les cellules photovoltaïques 4 peuvent être choisies parmi : des cellules photovoltaïques homojonction ou hétérojonction à base de silicium monocristallin (c-Si) et/ou multi-cristallin (mc-Si), et/ou des cellules photovoltaïques de type IBC, et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS) ou bien des cellules multi-jonctions (IIVV). Leur épaisseur est comprise entre 1 et 300µm, et notamment entre 1 et 200µm.

Les cellules photovoltaïques 4 peuvent présenter une épaisseur e4 comprise entre 1 et 300 µm, notamment entre 1 et 250 µm, voire entre 1 et 200 µm, et avantageusement entre 70 µm et 150 µm.

En outre, l'espacement entre deux cellules photovoltaïques voisines, ou encore consécutives ou adjacentes, peut être supérieur ou égal à 0,5 mm, notamment compris entre 1 et 30 mm, et de préférence égal à 2 mm.

En outre, les cellules photovoltaïques 4 peuvent être interconnectées par des rubans en cuivre étamé soudés. L'épaisseur des rubans d'interconnexion des cellules photovoltaïques est adaptée pour être compatible avec le procédé de lamination et la faible épaisseur de l'ensemble encapsulant. Les rubans d'interconnexion des cellules peuvent présenter une épaisseur inférieure à 100 µm et une largeur inférieure à 3 mm.

La deuxième couche 5 comprend un matériau composite de type préimprégné à base de résine polymère et de fibres présentant un poids surfacique inférieur à 150 g/m², et avantageusement compris entre 50 g/m² et 115 g/m². Elle peut être par exemple constituée par ledit au moins un matériau composite. La trame en tissu du préimprégné peut avoir un grammage inférieur ou égal à 50 g/m², et le taux d'imprégnation de résine polymère peut être compris entre 30 et 70 % en masse.

Le matériau composite de la deuxième couche 5 peut être un préimprégné à base de résine polymère et de fibres, le polymère étant choisi parmi le polyester, l'époxy et/ou l'acrylique, et les fibres étant choisies parmi les fibres de verre, de carbone et/ou d'aramide.

La deuxième couche 5 peut en particulier présenter une épaisseur e5 inférieure ou égale à 100 µm, notamment comprise entre 50 µm et 80 µm.

Dans les modes de réalisation représentés, la troisième couche 15 (ou couche de renforcement) est également en un matériau composite de type préimprégné à base de résine polymère et de fibres. Cela peut être un des matériaux listés ci-avant, en référence à la deuxième couche 5.

Selon un mode de réalisation préféré, la troisième couche 15 est le même matériau que la deuxième couche 5.

La troisième couche 15 peut en particulier présenter un grammage compris entre 50 g/m² et 150 g/m² La troisième couche peut en particulier présenter une épaisseur e15 inférieure ou égale à 100 µm, notamment comprise entre 50 µm et 80 µm.

Il est à noter que la première couche et/ou la deuxième couche du module photovoltaïque peuvent être formées en une ou plusieurs parties, à savoir qu'elles peuvent être monocouche ou multicouches.

La figure 3 illustre, en coupe et en vue éclatée, un premier mode de réalisation d'un module photovoltaïque 1 comprenant :
- une première couche 2 transparente formant la face avant du module photovoltaïque destinée à recevoir un flux lumineux,
- une pluralité de cellules photovoltaïques 4 disposées côte à côte et reliées électriquement entre elles,
- un ensemble encapsulant 3 comprenant une couche supérieure d'encapsulant 3a disposée au-dessus de la pluralité de cellules photovoltaïques 4 et une couche inférieure d'encapsulant 3b disposée en dessous de la pluralité de cellules photovoltaïques 4, l'ensemble étant apte à encapsuler la pluralité de cellules photovoltaïques,
- une deuxième couche 5 comportant au moins un matériau composite de type préimprégné à base de résine polymère et de fibres,
l'ensemble encapsulant 3 et la pluralité de cellules photovoltaïques 4 étant situés entre les première et deuxième couches.

La première couche 2 et la deuxième couche 5 définissent les bords du module photovoltaïque 1, et également l'ensemble encapsulant qui s'étend jusqu'aux bords du module.

En outre, la pluralité de cellules photovoltaïques 4 est distante d'une distance D_{A} d'un bord 1A du module photovoltaïque 1.

Le module photovoltaïque 1 comprend également une troisième couche 15, ou couche de renforcement, située en dessous de la pluralité de cellules photovoltaïques 4 et au-dessus de la couche inférieure d'encapsulant 3b. Cette troisième couche forme une bande périphérique 15A qui s'étend depuis le bord 1A et vient déborder en dessous de la cellule photovoltaïque 41 (ou des cellules photovoltaïques) la plus proche (les plus proches) du bord 1A. La largeur L_{15A} de cette bande périphérique est ainsi supérieure à la distance D_{A}.

A titre d'exemple, la distance D_{A} peut être égale à 50 mm et la largeur L_{15A} de la bande périphérique 15A égale à 70 mm. De manière plus générale, l'écart entre la largeur L_{15A} et la distance D_{A} est inférieur ou égal à 30 mm, de préférence inférieur ou égal à 20 mm, et encore plus préférentiellement compris entre 10 et 20 mm.

La figure 4 correspond à une vue de dessus d'un exemple de réalisation du mode de réalisation de la figure 3.

On voit que les cellules photovoltaïques sont distantes de tous les bords 1A, 1B, 1C, 1D du module photovoltaïque 1 d'une distance D_{A}, D_{B}, D_{C}, D_{D}. Quatre cellules photovoltaïques 41, 42, 43, 44 sont représentées mais ce nombre n'est pas limitatif, et il pourrait y en avoir plus, ou moins.

Ainsi, la troisième couche 15 forme quatre bandes périphériques 15A, 15B, 15C, 15D, une par bord 1A, 1B, 1C, 1D, formant ainsi un cadre. Chaque bande périphérique s'étendant depuis un bord et vient déborder en dessous des deux cellules photovoltaïques les plus proches du bord. La largeur L_{15A}(resp L_{15B}, L_{15C}, L_{15D}) de chaque bande périphérique illustrée est supérieure à la distance D_{A} (resp D_{B}, D_{C}, D_{D}) entre le bord parallèle à ladite bande et la pluralité de cellules photovoltaïques (4).

Dans le mode illustré de manière simplifiée en figure 4, toutes les distances sont sensiblement équivalentes, ainsi que les largeurs des bandes, ce qui n'est pas toujours le cas.

A titre d'exemple, les distances D_{A}, D_{B}, D_{C}, D_{D} peuvent être égales à 50 mm et les largeurs L_{15A}, L_{15B}, L_{15C}, L_{15D} des bandes périphériques 15A, 15B, 15C, 15D égales à 70 mm.

De manière plus générale, l'écart entre la largeur L_{15A} (resp L_{15B}, L_{15C}, L_{15D}) de bande de la troisième couche 15 et la distance D_{A} (resp D_{B}, D_{C}, D_{D}) entre le bord parallèle à ladite bande et les cellules est inférieur ou égal à 30 mm, de préférence inférieur ou égal à 20 mm, et encore plus préférentiellement compris entre 10 et 20 mm.

Par contre, les longueurs des bandes périphériques ne sont pas nécessairement égales afin de couvrir l'ensemble des bords sans recoupement, et ainsi former un cadre (sinon on peut envisager que chaque bande périphérique ait une forme en trapèze isocèle d'angle 45°). Alternativement, le cadre peut être d'un seul tenant.

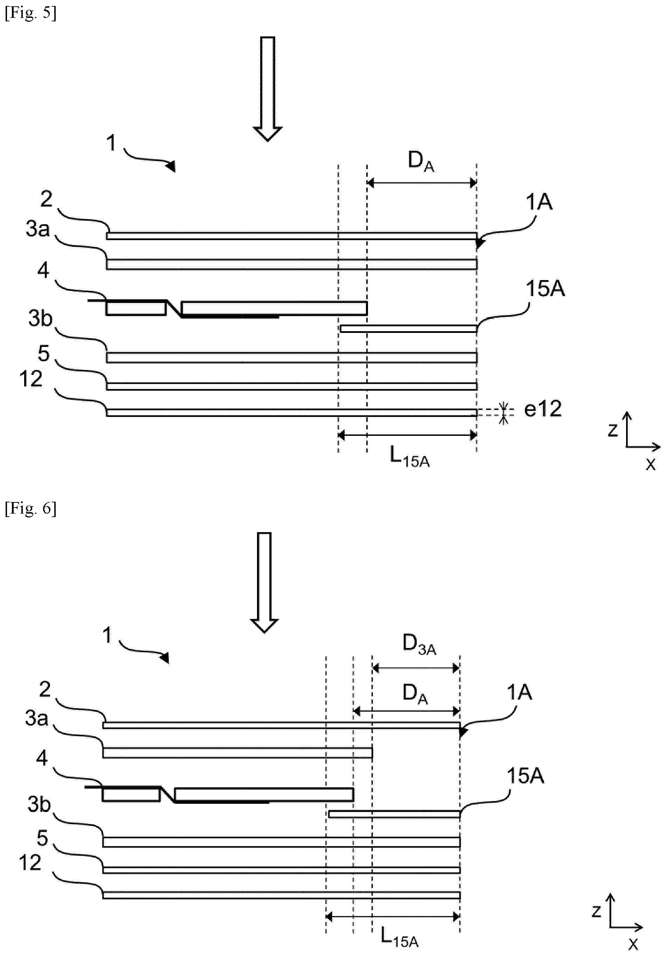

La figure 5 illustre, en coupe et en vue éclatée, une variante de réalisation du premier mode de réalisation.

Ce module photovoltaïque de la figure 5 peut comporter tout ou partie des caractéristiques décrites précédemment, et notamment celles en lien avec les figures 3 à 4 qui ne seront donc pas décrites de nouveau. Toutefois, dans cette variante, le module photovoltaïque 1 comporte une quatrième couche 12 formant la face arrière du module photovoltaïque 1, la deuxième couche 5 étant située entre la quatrième couche 12 et l'ensemble encapsulant 3.

Cette quatrième couche 12 est constituée par le même matériau que celui constituant la première couche 2 formant la face avant du module photovoltaïque 1. Avantageusement, ce matériau correspond à de l'éthylène chlorotrifluoroéthylène (ECTFE), également connu sous le nom Halar^{®}.

Par ailleurs, la quatrième couche 12 présente une épaisseur e12 inférieure, ou égale dans cette variante de la figure 5, à l'épaisseur e2 de la première couche 2.

La quatrième couche 12 permet avantageusement de réaliser une isolation diélectrique et chimique du module 1.

La quatrième couche 12 formant la face arrière est représentée également sur les figures 6 et 7. Cependant, elle pourrait être omise.

La figure 6 illustre, en coupe et en vue éclatée, un deuxième mode de réalisation d'un module photovoltaïque.

Ce module photovoltaïque de la figure 6 peut comporter tout ou partie des caractéristiques décrites précédemment, et notamment celles en lien avec les figures 3 à 5 qui ne seront donc pas décrites de nouveau.

Toutefois, dans ce deuxième mode, la couche d'encapsulant (3a) supérieure est distante d'une distance D₃ du bord 1A du module photovoltaïque. Cette distance D₃ est inférieure à la distance D_{A} de sorte que la couche d'encapsulant (3a) supérieure puisse encore protéger les cellules photovoltaïques.

La couche d'encapsulant (3a) supérieure peut être distante de tous les bords du module photovoltaïque, et notamment peut être distante d'une même distance D₃ de tous les bords du module photovoltaïque, comme par exemple dans une configuration du type des figures 4 et 8.

A titre d'exemple, la distance D_{A} peut être égale à 50 mm, la largeur L_{15A} de la bande périphérique 15A égale à 70 mm et la distance D₃ égale à 30 mm.

De manière plus générale, l'écart entre la largeur L_{15A} (resp L_{15B}, L_{15C}, L_{15D}) et la distance D_{A} (resp D_{B}, D_{C}, D_{D}) est inférieur ou égal à 30 mm, de préférence inférieur ou égal à 20 mm, et encore plus préférentiellement compris entre 10 et 20 mm, et l'écart entre D_{A} (resp D_{B}, D_{C}, D_{D}) et D₃ est inférieur ou égal à 10 mm.

La figure 7 illustre, en coupe et en vue éclatée, un troisième mode de réalisation d'un module photovoltaïque.

Ce module photovoltaïque de la figure 7 peut comporter tout ou partie des caractéristiques décrites précédemment, et notamment celles en lien avec les figures 3 à 5 qui ne seront donc pas décrites de nouveau. Toutefois, dans ce troisième mode, le module photovoltaïque comporte une cinquième couche 13 située en dessous de la deuxième couche 5 et au-dessus de la quatrième couche 12.

Cette cinquième couche forme au moins une bande périphérique 13A s'étendant depuis un bord 1A et vient déborder en dessous de la cellule photovoltaïque 41 (ou des cellules photovoltaïques) la plus proche (les plus proches) du bord 1A. La largeur L_{13A} de cette bande périphérique est supérieure à la distance D_{A}.

Cette cinquième couche 13 est de préférence en le même matériau que l'ensemble encapsulant 3. Alternativement, la cinquième couche est en un matériau différent du matériau de l'ensemble encapsulant mais il doit avoir au moins les mêmes propriétés thermomécaniques.

L'avantage de cette cinquième couche est de symétriser le bord et/ou les bords.

A titre d'exemple, la distance D_{A} peut être égale à 50 mm, la largeur L_{15A} de la bande périphérique 15A égale à 70 mm et la largeur L_{13A} de la bande périphérique 13A égale à 70 mm.

De manière plus générale, l'écart entre la largeur L_{13A} et la distance D_{A} est inférieur ou égal à 30 mm, de préférence inférieur ou égal à 20 mm et encore plus préférentiellement compris entre 10 et 20 mm.

De préférence, la largeur L_{13A} est égale à la largeur L_{15A}.

La figure 8 correspond à une vue de dessous d'un exemple de réalisation particulier du troisième mode de réalisation, dans laquelle on n'a représenté que la quatrième couche 12 (du dessous), la cinquième couche 13 et quatre cellules photovoltaïques 41, 42, 43, 44 (les couches 5, 3b, 15 qui sont entre la couche 13 et les cellules ne sont pas représentées, bien que présentes, pour rendre la figure plus lisible, de même pour les couches au-dessus des cellules).

On voit que les cellules photovoltaïques sont distantes de tous les bords 1A, 1B, 1C, 1D du module photovoltaïque 1 d'une distance D_{A}, D_{B}, D_{C}, D_{D}. Quatre cellules sont représentées mais ce nombre n'est pas limitatif, et il pourrait y en avoir plus, ou moins.

La cinquième couche 13 peut ainsi former quatre bandes périphériques, une par bord, comme par exemple représenté dans la configuration de la figure 8, formant ainsi également un cadre. Le cadre peut être d'un seul tenant.

Dans le mode illustré de manière simplifiée en figure 8, toutes les distances sont sensiblement équivalentes, ainsi que les largeurs des bandes, ce qui n'est pas toujours le cas.

A titre d'exemple, les distances D_{A}, D_{B}, D_{C}, D_{D} peuvent être égales à 50 mm, et les largeurs L_{13A}, L_{13B}, L_{13C}, L_{13D} des bandes périphériques 13A, 13B, 13C, 13D égales à 70 mm.

De manière plus générale, l'écart entre la largeur de bande L_{13A} (resp L_{13B}, L_{13C}, L_{13D}) de la cinquième couche et la distance D_{A} (resp D_{B}, D_{C}, D_{D}) est inférieur ou égal à 30 mm, de préférence inférieur ou égal à 20 mm et encore plus préférentiellement compris entre 10 et 20 mm.

De préférence, la largeur L_{13A}, (resp L_{13B}, L_{13C}, L_{13D}) de bande de la cinquième couche 13 est égale à la largeur L_{15A}, (resp L_{15B}, L_{15C}, L_{15D}) de bande de la troisième couche 15.

La cinquième couche 13 est de préférence de même forme géométrique que la troisième couche 15, de sorte qu'elles puissent se superposer.

La cinquième couche 13 peut en particulier présenter une épaisseur e13 inférieure ou égale à 150 µm, voire inférieure ou égale à 100 µm.

A titre d'exemple, et pour tout ou chacun des modes présentés précédemment :
- le matériau de la deuxième couche 5, et celui de la troisième couche 15, peut être un film composite préimprégné de type tissu de verre imprégné par une résine époxy tel que Hexply M77 de la société Hexcel ;
- la première couche 2 formant la face avant peut être un film d'éthylène chlorotrifluoroéthylène (ECTFE) (connu sous le nom « Halar ») de type ECT 020 de la société Rayotec, d'épaisseur de l'ordre de 20 µm ;
- les couches d'encapsulant 3a et 3b peuvent être des films de ionomères obtenus à partir de la gamme Jurasol^{™} commercialisée par la société Juraplast, d'épaisseur de l'ordre de 50 pm ; de même pour la cinquième couche 13 lorsqu'elle est incluse ;
- les cellules photovoltaïques 4 peuvent être des cellules hétérojonction à base de silicium amorphe et monocristallin d'épaisseur de l'ordre de 115 µm, ou des cellules de type IBC d'épaisseur de l'ordre de 160 µm.

La réalisation d'un module photovoltaïque 1 est effectuée en une seule étape de lamination à chaud, à une température comprise entre 130°C et 170°C, et notamment de l'ordre de 150°C, et pendant une durée du cycle de lamination d'au moins 10 minutes, et notamment comprise entre 10 et 20 minutes, des couches constitutives formant le module photovoltaïque 1.

Les différents modes de réalisation présentés peuvent être combinés entre eux.

En outre, la présente invention n'est pas limitée aux modes de réalisation précédemment décrits mais s'étend à tout mode de réalisation entrant dans la portée des revendications.

## Revendications

1. Module photovoltaïque (1) comportant :
- une première couche (2) transparente formant la face avant du module photovoltaïque (1) destinée à recevoir un flux lumineux,
- une pluralité de cellules photovoltaïques (4) disposées côte à côte et reliées électriquement entre elles,
- un ensemble encapsulant (3) apte à encapsuler la pluralité de cellules photovoltaïques (4), présentant une partie inférieure (3b) et une partie supérieure (3a), l'ensemble encapsulant étant de préférence en polymère,
- une deuxième couche (5) comportant au moins un matériau composite à base de résine polymère et de fibres,
l'ensemble encapsulant (3) et la pluralité de cellules photovoltaïques (4) étant situés entre les première (2) et deuxième (5) couches,
au moins la première couche (2) et la deuxième couche (5) définissant les bords (1A, 1B, 1C, 1D) du module photovoltaïque (1) ;
**caractérisé en ce que** la pluralité de cellules photovoltaïques (4) est espacée d'une distance D_{A} non nulle d'au moins un bord (1A) du module photovoltaïque (1), et **en ce que** le module photovoltaïque (1) comprend en outre une troisième couche (15), ou couche de renforcement, située en dessous de la pluralité de cellules photovoltaïques (4) et au-dessus de la partie inférieure (3b) de l'ensemble encapsulant (3), ladite troisième couche formant au moins une bande périphérique (15A) s'étendant depuis le au moins un bord (1A) vers le centre dudit module et dont la largeur (L_{15A}) est supérieure ou égale à la distance D_{A} ; ladite troisième couche comportant au moins un matériau composite à base de résine polymère et de fibres.

2. Module photovoltaïque (1) selon la revendication 1, l'écart entre la largeur (L_{15A}) de la au moins une bande périphérique (15A) et la distance D_{A} entre la pluralité de cellules photovoltaïques (4) et le au moins un bord (1A) étant inférieur ou égale à 30 mm, de préférence inférieur ou égale à 20 mm.

3. Module photovoltaïque (1) selon la revendication 1 ou la revendication 2, la troisième couche (15) et/ou de la deuxième couche (5) étant en matériau composite à base de polymère et de fibres,
- le polymère étant choisi de préférence parmi le polyester, l'époxy et/ou l'acrylique ; et/ou
- les fibres étant choisies de préférence parmi les fibres de verre, de carbone et/ou d'aramide.

4. Module photovoltaïque (1) selon l'une des revendications 1 à 3, la troisième couche (15) étant en le même matériau composite que la deuxième couche (5).

5. Module photovoltaïque (1) selon l'une des revendications 1 à 4, la troisième couche (15) formant plusieurs bandes périphériques (15A, 15B, 15C, 15D), de préférence au moins deux bandes opposées, et encore plus préférentiellement quatre bandes, chaque bande périphérique s'étendant depuis un bord (1A, 1B, 1C, 1D) du module photovoltaïque (1) vers le centre dudit module, la largeur (L_{15A}, L_{15B}, L_{15C}, L_{15D}) de chaque bande périphérique étant supérieure ou égale à la distance D_{A}, D_{B}, D_{C}, D_{D} entre ledit bord et la pluralité de cellules photovoltaïques (4), l'écart entre la largeur de chaque bande périphérique et la distance D_{A}, D_{B}, D_{C}, D_{D} étant de préférence inférieur ou égal à 30 mm, et encore plus préférentiellement inférieur ou égal à 20 mm.

6. Module photovoltaïque (1) selon l'une des revendications 1 à 5, l'ensemble encapsulant (3) s'étendant jusqu'aux bords (1A, 1B, 1C, 1D) du module photovoltaïque (1).

7. Module photovoltaïque (1) selon l'une des revendications 1 à 5, la partie supérieure (3a) de l'ensemble encapsulant (3) étant espacée d'une distance D_{3A} du au moins un bord (1A) du module photovoltaïque (1), la distance D_{3A} étant non nulle et inférieure à la distance D_{A} entre ledit au moins un bord et la pluralité de cellules photovoltaïques, l'écart entre lesdites distances D_{A} et D_{3A} étant de préférence inférieur ou égal à 10 mm.

8. Module photovoltaïque (1) selon l'une des revendications précédentes, comprenant en outre une cinquième couche (13), de préférence en polymère, située en dessous de la deuxième couche (5), ladite cinquième couche formant au moins une bande périphérique (13A) s'étendant depuis le au moins un bord (1A) vers le centre dudit module et dont la largeur (L_{13A}) est supérieure ou égale à la distance D_{A} entre ledit au moins un bord et la pluralité de cellules photovoltaïques, l'écart entre ladite largeur et ladite distance étant de préférence inférieur ou égal à 30 mm, et encore plus préférentiellement inférieur ou égal à 20 mm.

9. Module photovoltaïque (1) selon la revendication 8, la cinquième couche (13) formant plusieurs bandes périphériques (13A, 13B, 13C, 13D), de préférence au moins deux bandes opposées, et encore plus préférentiellement quatre bandes, chaque bande périphérique s'étendant depuis un bord (1A, 1B, 1C, 1D) du module photovoltaïque (1) vers le centre dudit module et la largeur (L_{13A}, L_{13B}, L_{13C}, L_{13D}) de chaque bande périphérique étant supérieure ou égale à la distance D_{A}, D_{B}, D_{C}, D_{D} entre ledit bord et la pluralité de cellules photovoltaïques (4), l'écart entre ladite largeur et ladite distance étant de préférence inférieur ou égal à 30 mm, et encore plus préférentiellement inférieur ou égal à 20 mm.

10. Module photovoltaïque (1) selon l'une des revendications 8 ou 9, la cinquième couche (13) étant en un matériau présentant les mêmes caractéristiques thermomécaniques que le matériau de l'ensemble encapsulant, de préférence en le même matériau que l'ensemble encapsulant (3).

11. Module photovoltaïque (1) selon l'une des revendications 8 à 10, les dimensions de la cinquième couche (13) étant sensiblement égales aux dimensions de la troisième couche (15).

12. Module photovoltaïque (1) selon l'une des revendications précédentes, comprenant en outre :
- une quatrième couche (12) formant la face arrière du module photovoltaïque (1), la deuxième couche (5) étant située entre l'ensemble encapsulant (3) et la quatrième couche (12), ladite quatrième couche étant constituée par le même matériau que celui constituant la première couche (2), et présentant une épaisseur inférieure ou égale à celle de la première couche (2).

13. Module photovoltaïque (1) selon l'une quelconque des revendications précédentes, la première couche (2) étant en un matériau polymère.

14. Module photovoltaïque (1) selon l'une quelconque des revendications précédentes, la première couche (2) présentant une épaisseur (e2) inférieure ou égale à 50 µm.

15. Module photovoltaïque (1) selon l'une quelconque des revendications précédentes, l'ensemble encapsulant (3) présentant une épaisseur maximale (e3) inférieure à 150 µm.

16. Module photovoltaïque (1) selon l'une quelconque des revendications précédentes, la deuxième couche (5) présentant un poids surfacique inférieur à 150 g/m².

17. Module photovoltaïque (1) selon l'une quelconque des revendications précédentes, l'ensemble encapsulant (3) comprenant une couche supérieure d'encapsulant (3a) disposée entre la première couche (2) et la pluralité de cellules photovoltaïques (4) et une couche inférieure d'encapsulant (3b) disposée entre la pluralité de cellules photovoltaïques (4) et la deuxième couche (5).

18. Procédé de réalisation d'un module photovoltaïque (1) choisi selon l'une quelconque des revendications 1 à 17, **caractérisé en ce qu'**il comporte une étape de lamination à chaud, à une température comprise entre 130°C et 170°C, notamment de l'ordre de 150°C, et pendant une durée du cycle de lamination d'au moins 10 minutes, notamment comprise entre 10 et 20 minutes, des couches constitutives du module photovoltaïque (1).

## Patentansprüche

1. Photovoltaikmodul (1), das Folgendes aufweist:
- eine transparente erste Schicht (2), die die Vorderseite des Photovoltaikmoduls (1) bildet, die dazu bestimmt ist, einen Lichtstrom zu empfangen,
- eine Vielzahl von photovoltaischen Zellen (4), die Seite an Seite angeordnet und elektrisch miteinander verbunden sind,
- eine Einkapselungsanordnung (3), die die Vielzahl von photovoltaischen Zellen (4) einkapseln kann und einen unteren Teil (3b) und einen oberen Teil (3a) aufweist, wobei die Einkapselungsanordnung vorzugsweise aus Polymer besteht,
- eine zweite Schicht (5), die mindestens ein Verbundmaterial auf Polymerharz- und Faserbasis umfasst,
wobei sich die Einkapselungsanordnung (3) und die Vielzahl von photovoltaischen Zellen (4) zwischen der ersten (2) und der zweiten (5) Schicht befinden,
wobei mindestens die erste Schicht (2) und die zweite Schicht (5) die Ränder (1A, 1B, 1C, 1D) des Photovoltaikmoduls (1) definieren;
**dadurch gekennzeichnet, dass** die Vielzahl von photovoltaischen Zellen (4) in einer Distanz D_{A} von ungleich Null von mindestens einem Rand (1A) des Photovoltaikmoduls (1) beabstandet ist, und dadurch, dass das Photovoltaikmodul (1) ferner eine dritte Schicht (15) oder Verstärkungsschicht umfasst, die sich unter der Vielzahl von photovoltaischen Zellen (4) und über dem unteren Teil (3b) der Einkapselungsanordnung (3) befindet, wobei die dritte Schicht mindestens einen peripheren Streifen (15A) bildet, der sich von dem mindestens einen Rand (1A) zur Mitte des Moduls hin erstreckt und dessen Breite (L_{15A}) gleich der oder größer als die Distanz D_{A} ist; wobei die dritte Schicht mindestens ein Verbundmaterial auf Polymerharz- und Faserbasis umfasst.

2. Photovoltaikmodul (1) nach Anspruch 1, wobei die Differenz zwischen der Breite (L_{15A}) des mindestens einen peripheren Streifens (15A) und der Distanz D_{A} zwischen der Vielzahl von photovoltaischen Zellen (4) und dem mindestens einen Rand (1A) kleiner als oder gleich 30 mm, vorzugsweise kleiner als oder gleich 20 mm ist.

3. Photovoltaikmodul (1) nach Anspruch 1 oder Anspruch 2, wobei die dritte Schicht (15) und/oder die zweite Schicht (5) aus einem Verbundmaterial auf Polymerharz- und Faserbasis besteht,
- wobei das Polymer vorzugsweise aus Polyester, Epoxy und/oder Acryl ausgewählt ist; und/oder
- wobei die Fasern vorzugsweise aus Glas-, Kohlenstoff- und/oder Aramidfasern ausgewählt sind.

4. Photovoltaikmodul (1) nach einem der Ansprüche 1 bis 3, wobei die dritte Schicht (15) aus demselben Verbundmaterial wie die zweite Schicht (5) besteht.

5. Photovoltaikmodul (1) nach einem der Ansprüche 1 bis 4, wobei die dritte Schicht (15) mehrere periphere Streifen (15A, 15B, 15C, 15D), vorzugsweise mindestens zwei gegenüberliegende Streifen und noch bevorzugter vier Streifen bildet, wobei sich jeder periphere Streifen von einem Rand (1A, 1B, 1C, 1D) des Photovoltaikmoduls (1) zur Mitte des Moduls erstreckt, wobei die Breite (L_{15A}, L_{15B}, L_{15C}, L_{15D}) jedes peripheren Streifens gleich der oder größer als die Distanz D_{A}, D_{B}, D_{C}, D_{D} zwischen dem Rand und der Vielzahl von photovoltaischen Zellen (4) ist, wobei die Differenz zwischen der Breite jedes peripheren Streifens und der Distanz D_{A}, D_{B}, D_{C}, D_{D} vorzugsweise kleiner als oder gleich 30 mm und noch bevorzugter kleiner als oder gleich 20 mm ist.

6. Photovoltaikmodul (1) nach einem der Ansprüche 1 bis 5, wobei sich die Einkapselungsanordnung (3) bis zu den Rändern (1A, IB, 1C, 1D) des Photovoltaikmoduls (1) erstreckt.

7. Photovoltaikmodul (1) nach einem der Ansprüche 1 bis 5, wobei der obere Teil (3a) der Einkapselungsanordnung (3) um eine Distanz D_{3A} von dem mindestens einen Rand (1A) des Photovoltaikmoduls (1) beabstandet ist, wobei die Distanz D_{3A} ungleich Null und kleiner als die Distanz D_{A} zwischen dem mindestens einen Rand und der Vielzahl von photovoltaischen Zellen ist, wobei der Abstand zwischen den Distanzen D_{A} und D_{3A} vorzugsweise kleiner als oder gleich 10 mm ist.

8. Photovoltaikmodul (1) nach einem der vorhergehenden Ansprüche, das ferner eine fünfte Schicht (13), die vorzugsweise aus Polymer besteht, umfasst, die unter der zweiten Schicht (5) angeordnet ist, wobei die fünfte Schicht mindestens einen peripheren Streifen (13A) bildet, der sich von dem mindestens einen Rand (1A) zur Mitte des Moduls hin erstreckt und dessen Breite (L_{13A}) gleich der oder größer als die Distanz D_{A} zwischen dem mindestens einen Rand und der Vielzahl von photovoltaischen Zellen ist, wobei die Differenz zwischen der Breite und der Distanz vorzugsweise kleiner als oder gleich 30 mm und noch bevorzugter kleiner als oder gleich 20 mm ist.

9. Photovoltaikmodul (1) nach Anspruch 8, wobei die fünfte Schicht (13) mehrere periphere Streifen (13A, 13B, 13C, 13D), vorzugsweise mindestens zwei gegenüberliegende Streifen und noch bevorzugter vier Streifen bildet, wobei sich jeder periphere Streifen von einem Rand (1A, 1B, 1C, 1D) des Photovoltaikmoduls (1) zur Mitte des Moduls erstreckt und die Breite (L_{13A}, L_{13B}, L_{13C}, L_{13D}) jedes peripheren Streifens gleich der oder größer als die Distanz D_{A}, D_{B}, D_{C}, D_{D} zwischen dem Rand und der Vielzahl von photovoltaischen Zellen (4) ist, wobei die Differenz zwischen der Breite und der Distanz vorzugsweise kleiner als oder gleich 30 mm und noch bevorzugter kleiner als oder gleich 20 mm ist.

10. Photovoltaikmodul (1) nach einem der Ansprüche 8 oder 9, wobei die fünfte Schicht (13) aus einem Material mit den gleichen thermomechanischen Eigenschaften wie das Material der Einkapselungsanordnung, vorzugsweise aus dem gleichen Material wie die Einkapselungsanordnung (3) besteht.

11. Photovoltaikmodul (1) nach einem der Ansprüche 8 bis 10, wobei die Abmessungen der fünften Schicht (13) im Wesentlichen gleich den Abmessungen der dritten Schicht (15) sind.

12. Photovoltaikmodul (1) nach einem der vorhergehenden Ansprüche, das ferner Folgendes umfasst:
- eine vierte Schicht (12), die die Rückseite des Photovoltaikmoduls (1) bildet, wobei sich die zweite Schicht (5) zwischen der Einkapselungsanordnung (3) und der vierten Schicht (12) befindet, wobei die vierte Schicht aus demselben Material wie das der ersten Schicht (2) besteht und eine Dicke aufweist, die gleich der oder kleiner als die erste(n) Schicht (2) ist.

13. Photovoltaikmodul (1) nach einem der vorhergehenden Ansprüche, wobei die erste Schicht (2) aus einem polymeren Material besteht.

14. Photovoltaikmodul (1) nach einem der vorhergehenden Ansprüche, wobei die erste Schicht (2) eine Dicke (e2) kleiner als oder gleich 50 µm aufweist.

15. Photovoltaikmodul (1) nach einem der vorhergehenden Ansprüche, wobei die Einkapselungsanordnung (3) eine maximale Dicke (e3) von weniger als 150 µm aufweist.

16. Photovoltaikmodul (1) nach einem der vorhergehenden Ansprüche, wobei die zweite Schicht (5) ein Flächengewicht von weniger als 150 g/m² aufweist.

17. Photovoltaikmodul (1) nach einem der vorhergehenden Ansprüche, wobei die Einkapselungsanordnung (3) eine zwischen der ersten Schicht (2) und der Vielzahl von photovoltaischen Zellen (4) angeordnete obere Einkapselungsschicht (3a) und eine zwischen der Vielzahl von photovoltaischen Zellen (4) und der zweiten Schicht (5) angeordnete untere Einkapselungsschicht (3b) umfasst.

18. Verfahren zur Herstellung eines Photovoltaikmodul (1), ausgewählt nach einem der Ansprüche 1 bis 17, **dadurch gekennzeichnet, dass** es einen Heißlaminierungsschritt bei einer Temperatur zwischen 130°C und 170°C, insbesondere in der Größenordnung von 150°C, und während einer Dauer des Laminierzyklus von mindestens 10 Minuten, insbesondere zwischen 10 und 20 Minuten, der das Photovoltaikmodul (1) bildenden Schichten aufweist.

## Claims

1. A photovoltaic module (1) having:
- a transparent first layer (2) forming the front side of the photovoltaic module (1), which is intended to receive a light flux,
- a plurality of photovoltaic cells (4) placed side-by-side and electrically connected to one another,
- an encapsulating assembly (3) able to encapsulate the plurality of photovoltaic cells (4), and having a lower portion (3b) and an upper portion (3a), the encapsulating assembly preferably being made of polymer,
- a second layer (5) having at least one polymer resin- and fibre-based composite material,
the encapsulating assembly (3) and the plurality of photovoltaic cells (4) being located between the first (2) and second (5) layers,
at least the first layer (2) and the second layer (5) defining the edges (1A, 1B, 1C, 1D) of the photovoltaic module (1);
**characterised in that** the plurality of photovoltaic cells (4) is spaced apart by a non-zero distance D_{A} from at least one edge (1A) of the photovoltaic module (1), and **in that** the photovoltaic module (1) further comprises a third layer (15), or strengthening layer, located below the plurality of photovoltaic cells (4) and above the lower portion (3b) of the encapsulating assembly (3), said third layer forming at least one peripheral strip (15A) extending from the at least one edge (1A) toward the centre of said module and the width (L_{15A}) of which is larger than or equal to the distance D_{A}, said third layer comprising at least one polymer resin- and fibre-based composite material.

2. The photovoltaic module (1) according to claim 1, the difference between the width (L_{15A}) of the at least one peripheral strip (15A) and the distance D_{A} between the plurality of photovoltaic cells (4) and the at least one edge (1A) being smaller than or equal to 30 mm, and preferably smaller than or equal to 20 mm.

3. The photovoltaic module (1) according to claim 1 or claim 2, the third layer (15) and/or the second layer (5) being made of a polymer resin- and fibre-based composite material,
- the polymer preferably being chosen from polyester, epoxy and/or acrylic; and/or
- the fibres preferably being chosen from glass fibres, carbon fibres and/or aramid fibres.

4. The photovoltaic module (1) according to one of claims 1 to 3, the third layer (15) being made of the same composite material as the second layer (5).

5. The photovoltaic module (1) according to one of claims 1 to 4, the third layer (15) forming multiple peripheral strips (15A, 15B, 15C, 15D), preferably at least two opposite strips, and even more preferably four strips, each peripheral strip extending from one edge (1A, 1B, 1C, 1D) of the photovoltaic module (1) toward the centre of said module, the width (L_{15A}, L_{15B}, L_{15C}, L_{15D}) of each peripheral strip being larger than or equal to the distance D_{A}, D_{B}, D_{C}, D_{D} between said edge and the plurality of photovoltaic cells (4), the difference between the width of each peripheral strip and the distance D_{A}, D_{B}, D_{C}, D_{D} preferably being smaller than or equal to 30 mm, and even more preferably smaller than or equal to 20 mm.

6. The photovoltaic module (1) according to one of claims 1 to 5, the encapsulating assembly (3) extending up to the edges (1A, 1B, 1C, 1D) of the photovoltaic module (1).

7. The photovoltaic module (1) according to one of claims 1 to 5, the upper portion (3a) of the encapsulating assembly (3) being spaced apart by a distance D_{3A} from the at least one edge (1A) of the photovoltaic module (1), the distance D_{3A} being non-zero and smaller than the distance D_{A} between said at least one edge and the plurality of photovoltaic cells, the difference between said distances D_{A} and D_{3A} preferably being smaller than or equal to 10 mm.

8. The photovoltaic module (1) according to one of the preceding claims, further comprising a fifth layer (13), which is preferably made of polymer, located below the second layer (5), said fifth layer forming at least one peripheral strip (13A) extending from the at least one edge (1A) toward the centre of said module and the width (L_{13A}) of which is larger than or equal to the distance D_{A} between said at least one edge and the plurality of photovoltaic cells, the difference between said width and said distance preferably being smaller than or equal to 30 mm, and even more preferably smaller than or equal to 20 mm.

9. The photovoltaic module (1) according to claim 8, the fifth layer (13) forming multiple peripheral strips (13A, 13B, 13C, 13D), preferably at least two opposite strips, and even more preferably four strips, each peripheral strip extending from one edge (1A, 1B, 1C, 1D) of the photovoltaic module (1) toward the centre of said module and the width (L_{13A}, L_{13B}, L_{13C}, L_{13D}) of each peripheral strip being larger than or equal to the distance D_{A}, D_{B}, D_{C}, D_{D} between said edge and the plurality of photovoltaic cells (4), the difference between said width and said distance preferably being smaller than or equal to 30 mm, and even more preferably smaller than or equal to 20 mm.

10. The photovoltaic module (1) according to one of claims 8 or 9, the fifth layer (13) being made of a material having the same thermomechanical characteristics as the material of the encapsulating assembly, preferably of the same material as the encapsulating assembly (3).

11. The photovoltaic module (1) according to one of claims 8 to 10, the dimensions of the fifth layer (13) being substantially equal to the dimensions of the third layer (15).

12. The photovoltaic module (1) according to one of the preceding claims, further comprising:
- a fourth layer (12) forming the back side of the photovoltaic module (1), the second layer (5) being located between the encapsulating assembly (3) and the fourth layer (12), said fourth layer being made of the same material as the material from which the first layer (2) is made, and having a thickness smaller than or equal to that of the first layer (2).

13. The photovoltaic module (1) according to any one of the preceding claims, the first layer (2) being made of a polymer material.

14. The photovoltaic module (1) according to any one of the preceding claims, the first layer (2) having a thickness (e2) smaller than or equal to 50 µm.

15. The photovoltaic module (1) according to any one of the preceding claims, the encapsulating assembly (3) having a maximum thickness (e3) smaller than 150 µm.

16. The photovoltaic module (1) according to any one of the preceding claims, the second layer (5) having a weight per unit area lower than 150 g/m².

17. The photovoltaic module (1) according to any one of the preceding claims, the encapsulating assembly (3) comprising an upper encapsulating layer (3a) placed between the first layer (2) and the plurality of photovoltaic cells (4) and a lower encapsulating layer (3b) placed between the plurality of photovoltaic cells (4) and the second layer (5).

18. A process for producing a photovoltaic module (1) chosen according to any one of claims 1 to 17, **characterised in that** it contains a step of hot lamination, at a temperature of between 130°C and 170°C, and in particular of about 150°C, and during a lamination cycle lasting at least 10 minutes, in particular between 10 and 20 minutes, of the layers from which the photovoltaic module (1) is made.
